# FASCICULE DE BREVET EUROPEEN

(11) **EP 0 540 416 B1**
(45) Date de publication et mention de la délivrance du brevet: **20.03.1996**
(21) Numéro de dépôt: 92402930.9
(22) Date de dépôt: 28.10.1992
(51) Int. Cl.: H01L 39/24

(54) **Procédé de fabrication d'un conducteur souple supraconducteur à haute température critique et conducteur en résultant**
Verfahren zur Herstellung eines flexiblen Hochtemperatur-Supraleiters und resultierender Leiter
Method of making a flexible high temperature superconductor and resulting conductor

(30) Priorité: 29.10.1991 FR 9113313
(43) Date de publication de la demande: 05.05.1993
(73) Titulaire: ALCATEL CABLE, F-92111 Clichy Cédex (FR)
(72) Inventeur: Petitbon, Alain, F-78730 Saint Arnoult en Yvelines (FR); Queriaud, Roland, Résidence de l'Esplanade, F-91400 Orsay (FR)
(74) Mandataire: Weinmiller, Jürgen

(56) Documents cités:
- GB-A- 2 220 426
- US-A- 5 057 484
- PATENT ABSTRACTS OF JAPAN vol. 13, no. 123 (E-733)27 Mars 1989 & JP-A-63292530

## Description

La présente invention concerne un procédé de fabrication d'un conducteur souple supraconducteur à haute température critique, c'est-à-dire à base de céramique supraconductrice de type YBaCuO, BiSrCaCuO, TlBaCaCuO...

On connaît des procédés de réalisation de supraconducteurs à haute température critique selon lesquels on part de poudre de l'oxyde supraconducteur, on réalise des pastilles compactées frittées, on fait fondre superficiellement ces pastilles à l'aide d'un faisceau laser ; la couche fondue est rapidement solidifiée puis soumise à un recuit. Ces procédés sont décrits dans les articles suivants :
- "Concentration of current to the surface and modification by CO₂ laser for oxide superconductor" par H. Nomura et al ; 2nd International Symposium on Superconductivity Nov. 1989, Tsukuba (p.423 à 426).
- "The microstructure and superconductivity of YBa₂CuO₇₋ₓ rapidly solidified by a pulse laser" par J.C. Huang et al ; Supercond. Sci. Technol. 1, 1988 ; (p.110 à 112).
- "Laser zone melting of Bi₂Sr₂CaCuOₓ superconductors" par K. Ishige et al ; 2nd International Symposium on Superconductivity Nov. 1989, Tsukuba (p.321 à 324).

Les paramètres expérimentaux divulgués dans ces documents ne permettent pas d'obtenir une texturation avec des grains allongés dans la même direction. En outre tous les traitements décrits sont effectués sur des pastilles dont l'épaisseur est supérieure à un millimètre ; ceci est totalement incompatible avec la réalisation d'un supraconducteur souple.

La difficulté essentielle est qu'une céramique supraconductrice est un matériau fragile possédant des propriétés mécaniques rendant très difficile sa fabrication en tant que conducteur souple surtout sur de grandes longueurs.

Pour pallier ces problèmes de fragilité, on a tenté d'associer la céramique à un support métallique.

On réalise par exemple des fils gainés de métal, sous forme de monofilament ou de multifilament ; cette méthode présente l'inconvénient de nécessiter de nombreuses étapes de mise en forme mécanique, en particulier d'étirage, et des cuissons intermédiaires. En outre il existe un grand risque de réaction entre la céramique et la gaine, ce qui peut détruire la supraconductivité étant donné le très faible diamètre du fil en céramique.

Selon un autre mode de réalisation décrit dans la demande de brevet JP-A-2257527, on dépose la céramique autour d'un fil métallique en couche très mince, par mouillage du fil qui traverse un bain d'un oxyde fondu de type Y-Ba-Cu-O. Pour que se forme une phase supraconductrice à la sortie du bain sur le fil, la vitesse de défilement doit être très faible, ce qui entraîne une réaction prohibitive entre le bain et le matériau du fil.

Une technique beaucoup plus prometteuse consiste à disposer la céramique sur un ruban métallique souple et sous forme d'une couche épaisse, de quelques centaines de microns d'épaisseur.

Différentes méthodes ont déjà été proposées pour obtenir des couches épaisses de céramique supraconductrice : coulage en bande, sérigraphie, calandrage, projection par arc électrique, projection par flamme. Les couches obtenues sont plus ou moins poreuses, et plus au moins bien cristallisées suivant la méthode employée ; elles subissent ensuite un recuit. Des procédés de ce type mettant en oeuvre des plasmas sont décrits dans les documents suivants :
- "High Tc superconducting films of YBaCu oxides prepared by low pressure plasma spraying" par K. Tachikawa et al ; Appl. Phys. Lett. 52(12), 1988.
- "Formation of YBaCuO thick films by plasma spraying" par Y. Wadayama et al ; 2nd International Symposium on superconductivity Nov. 1989 Tsukuba.

Les densités de courant maximales obtenues respectivement avec ces deux procédés ne sont que de 690A/cm et de 1120A/cm, ce qui est insuffisant.

Enfin, on a proposé dans la demande de brevet JP-A-63 292530 et dans le brevet français FR-A- 2 647 266 un procédé selon lequel un précurseur de matériau supraconducteur est posé sur un substrat à l'état de poudre, puis chauffé par un faisceau laser de façon à réaliser une couche adhérant au substrat. La solidarisation ne peut se produire que si le faisceau laser agit suivant toute l'épaisseur de poudre de précurseurs; il agit donc également sur le substrat, ce qui est particulièrement néfaste lorsque le substrat est un matériau souple de quelques dixièmes de millimètres d'épaisseur ; selon une autre variante la poudre est projetée sur le substrat à travers le faisceau laser.

Cette technique n'aboutit pas non plus à la texturation de la couche supraconductrice. En outre, comme le taux de densification du matériau pulvérulent déposé sur le substrat ne peut être supérieur à 30%, la densification résultant du traitement laser induit dans ce matériau des contraintes très importantes qui sont libérées par fissuration, ce qui s'oppose au passage du courant.

La présente invention a pour but de mettre en oeuvre un procédé pour réaliser un supraconducteur souple, procédé aboutissant à un matériau texturé susceptible de transporter des densités de courant très supérieures à celles des conducteurs souples connus.

La présente invention a pour objet un procédé de fabrication d'un conducteur souple supraconducteur à haute température critique selon lequel on applique sur un ruban métallique d'épaisseur comprise entre 0,1 mm et 1 mm un dépôt de céramique supraconductrice, procédé caractérisé par le fait:
- que ledit dépôt, d'épaisseur comprise entre 50 µm et 300 µm, avec un taux de densification au moins égal à 70%, défile dans un faisceau infrarouge avec une vitesse au moins égale à 5 cm par minute, la zone traitée par ledit faisceau présentant, dans le sens du défilement, une largeur inférieure à 10 mm et une température de surface au moins égale à 1200°C, de manière à conférer audit dépôt une couche supraconductrice superficielle avec un taux de densification proche de 100%, texturée dans le sens de défilement, présentant une épaisseur comprise entre 10 µm et 100 µm,
- et que l'on effectue ensuite un recuit sous oxygène.

La présente invention a également pour objet un conducteur souple obtenu par le procédé précédent.

Avantageusement l'application dudit dépôt sur ledit ruban est effectuée par coulage en bande, calandrage, projection par arc électrique, projection par flamme, projection laser, et, dans la même opération de fabrication,elle est directement suivie du traitement infrarouge selon l'invention et du recuit précité, selon un procédé continu. Les contraintes mécaniques dans le dépôt se trouvent ainsi réduits.

De préférence:
- Ladite température de surface est comprise entre 1200°C et 1500°C.
- Le faisceau infrarouge est issu d'un laser CO₂ pulsé à une fréquence comprise entre 50 et 1000 Hz avec une puissance comprise entre 100 et 1000 W/cm, avantageusement entre 400 et 800 W/cm.
- L'épaisseur de ladite couche supraconductrice est comprise entre 10 µm et 50 µm.
- L'épaisseur dudit dépôt est comprise entre 100 µm et 200 µm.
- L'épaisseur dudit ruban métallique est comprise entre 0,1 mm et 0,5 mm ; son matériau est choisi parmi le cuivre, l'argent, les aciers inoxydables, les superalliages à base de nickel, les superalliages à base de cobalt.

La maîtrise des paramètres du procédé selon l'invention qui viennent d'être définis permet d'obtenir à la surface du dépôt, dans l'axe du balayage laser, des gradients thermiques compris entre 100 et 1000°C par millimètre et des vitesses de refroidissement comprises entre 5000°C et 10 000°C par seconde. Grâce à la rapidité de la fusion superficielle du dépôt et du refroidissement de la couche fondue, on évite l'échauffement excessif de l'interface ruban-dépôt et du ruban lui-même. Ceci diminue les risques de décollement du dépôt, de réactions entre le dépôt et le ruban, et d'oxydation du ruban.

En outre, la couche superficielle est dense et non fissurée, avec une texturation et une orientation cristalline parallèles à la direction du balayage laser, autrement dit dans le sens de la longueur dudit ruban.

Ladite opération de recuit est indispensable pour restaurer la phase supraconductrice et réoxygéner. Cette opération comprend un chauffage jusqu'à une température comprise entre 850°C et 950°C, un palier de durée comprise entre 1 heure et 6 heures à cette température, et une vitesse de refroidissement comprise entre 10°C/heure et 100°C/heure, et de préférence comprise entre 10°C/heure et 50°C/heure.

Les conditions opératoires peuvent être choisies pour que la densité de courant critique atteigne une valeur de l'ordre de 100A/mm, c'est-à-dire une valeur très supérieure à celle des rubans supraconducteurs de l'art antérieur.

Selon une variante de réalisation, on peut prévoir sur ledit ruban une sous-couche pour améliorer l'adhérence du dépôt, et en particulier harmoniser les coefficients de dilatation et limiter les interaction chimiques entre le ruban et le dépôt, au cours des traitements thermiques. La sous-couche est par exemple en argent ou en alliage de type NiCrAlY, CoCrAlY, NiAl. Son épaisseur est comprise entre 10 µm et 200 µm, et de préférence comprise entre 10 µm et 100 µm.

Par ailleurs la composition dudit dépôt peut être soit stoechiométrique vis-à-vis de la phase supraconductrice, soit enrichie en éléments susceptibles de se volatiliser durant le traitement du laser, par exemple en cuivre.

D'autres caractéristiques et avantages de la présente invention apparaîtront au cours de la description suivante de modes de réalisation donnés à titre illustratif mais nullement limitatif. Dans le dessin annexé :
- La figure 1 est une vue très schématique d'une installation mettant en oeuvre le procédé selon l'invention en continu.
- Les figures 2A et 2B sont respectivement des vues de dessus et en coupe d'un ruban métallique souple selon l'invention après son passage sous les torches à arc électrique de l'installation de la figure 1.
- La figure 3 est une vue de dessus du ruban de la figure 2A pendant son passage dans le faisceau laser.
- La figure 4 est une vue en coupe transversale du ruban de la figure 3, limitée à la zone où le faisceau laser a texturé superficiellement sa surface.
- La figure 5 est une photographie (grandissement x 100) de la surface d'une couche supraconductrice sans traitement laser selon l'invention.
- La figure 6 est une photographie de la surface d'une couche supraconductrice selon l'invention (x 100).
- La figure 7 est une photographie d'une zone de la couche de la figure 6 (x 750) montrant sa texturation dans la direction du balayage laser.
- La figure 8 montre des courbes de courant critique correspondant respectivement aux couches des figures 5 et 6.
- La figure 9 montre des courbes de température critique correspondant respectivement aux couches des figures 5 et 6.

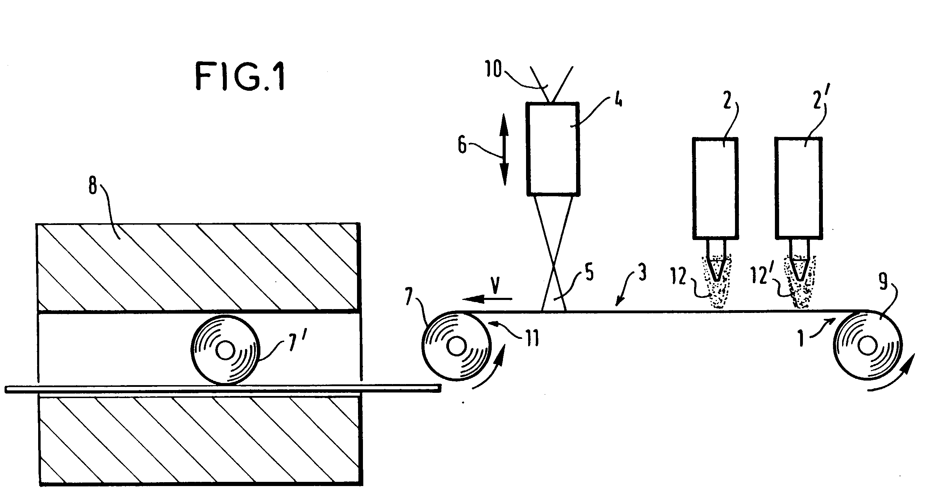

On voit dans la figure 1 le schéma d'une installation mettant en oeuvre le procédé en continu selon l'invention. Un ruban métallique souple 1, enroulé sur une bobine 9, défile sous une torche à arc électrique 2 qui projette sur ce ruban 1 une composition 12 de céramique supraconductrice, de manière à réaliser un dépôt d'épaisseur comprise entre 50 µm et 300 µm et dont le taux de densification est supérieur à 70%, cette torche 2 peut être précédée d'une torche 2′ de même type projetant au préalable un matériau 12′ destiné à améliorer l'adhérence de la composition 12 sur le ruban métallique 1. On a référencé 3 le ruban souple muni de son dépôt. Le ruban 3 défile ensuite à la vitesse V sous un faisceau 5 issu d'un laser infrarouge 10 associé à un système 4 d'homogénéisation de faisceau. Un réglage du laser selon l'axe 6 orthogonal au ruban souple 3 permet de régler le diamètre du faisceau 5. Un pyromètre bichromatique à réponse rapide (non illustré) mesure la température de surface de la zone du dépôt traitée par le faisceau 5.

Le conducteur souple 11 ainsi traité est enroulé sur une bobine 7 qui est introduite ensuite (position 7′) dans un four de recuit 8, par exemple un four tunnel.

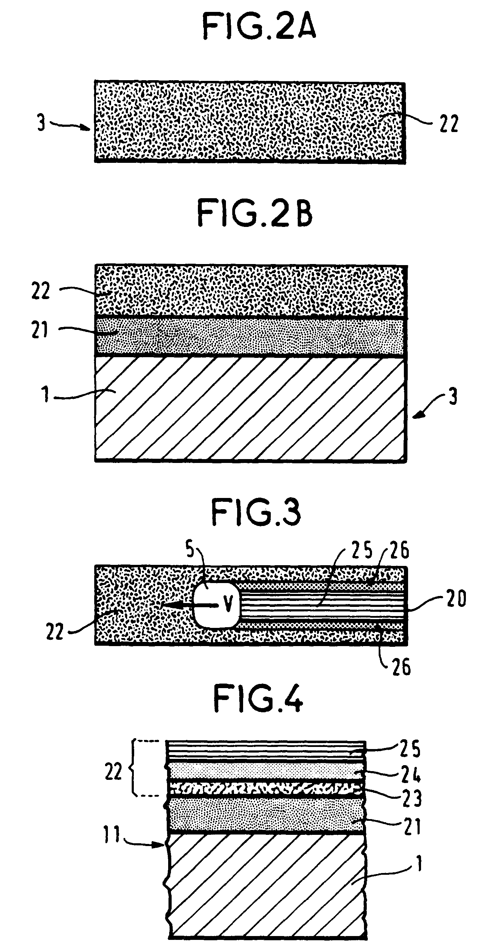

Les figures 2A et 2B montrent le ruban souple 3, après son passage sous les torches 2 et 2′, avec le ruban métallique originel 1, une sous-couche 21 et un dépôt 22 de céramique supraconductrice.

La figure 3 montre la trace du faisceau laser 5 sur le dépôt 22 lorsque le ruban souple 3 défile à la vitesse V ; on a référencé une zone centrale de traitement 20 et deux lisières 26 balayées par les bords du faisceau laser 5.

La figure 4 montre en coupe transversale l'effet de ce faiseau laser 5 dans la zone centrale 20. On retrouve la sous-couche 21 sur le ruban métallique 1, mais le dépôt de céramique 22 a été notablement transformé par le traitement laser. On distingue :
- une zone de réaction 23 entre la sous-couche 21 et la céramique ; cette zone n'est pas supraconductrice ;
- une zone 24 de céramique non traitée par le faisceau laser 5, et qui a gardé la même nature que le dépôt 22 proprement dit ; cette zone est peu conductrice ;
- une couche superficielle 25 fondue par le faisceau laser, dense et texturée dans le sens de défilement du ruban 1.

On remarque que les lisières 26 de la zone 25 sont texturées sensiblement à 45 degrés vis-à-vis de cette couche 25.

### Exemple I

On part d'un ruban 1 en acier inoxydable NS225, d'épaisseur 0,3mm et de 10mm de large. On munit ce ruban d'une sous-couche 21 d'épaisseur 100 µm en alliage NiCrAlY.
On réalise un dépôt 22 de 100 µm avec une torche à plasma ayant pour composition YBa₂Cu₃Oₓ. On prélève un échantillon que l'on recuit 6 heures à 900°C sous oxygène et que l'on refroidit à 20°C/heure.

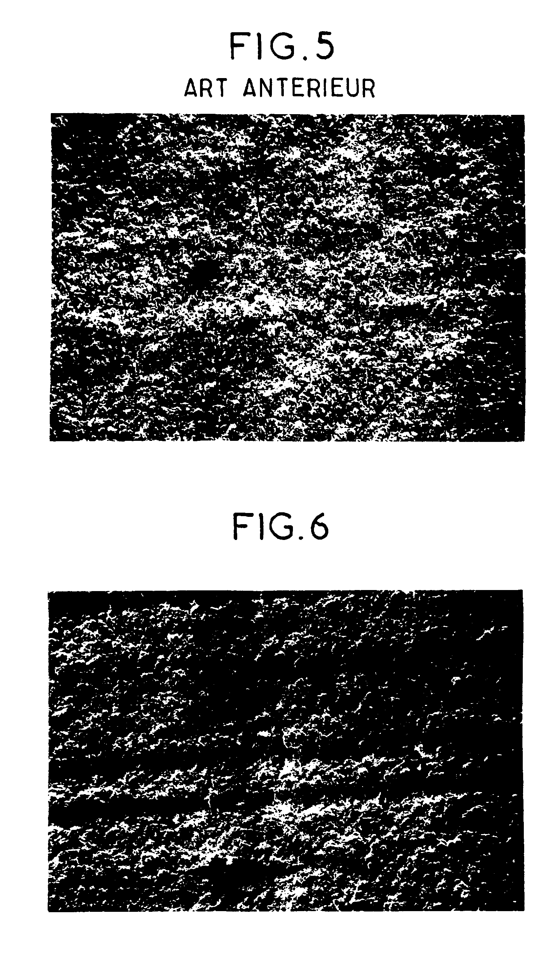

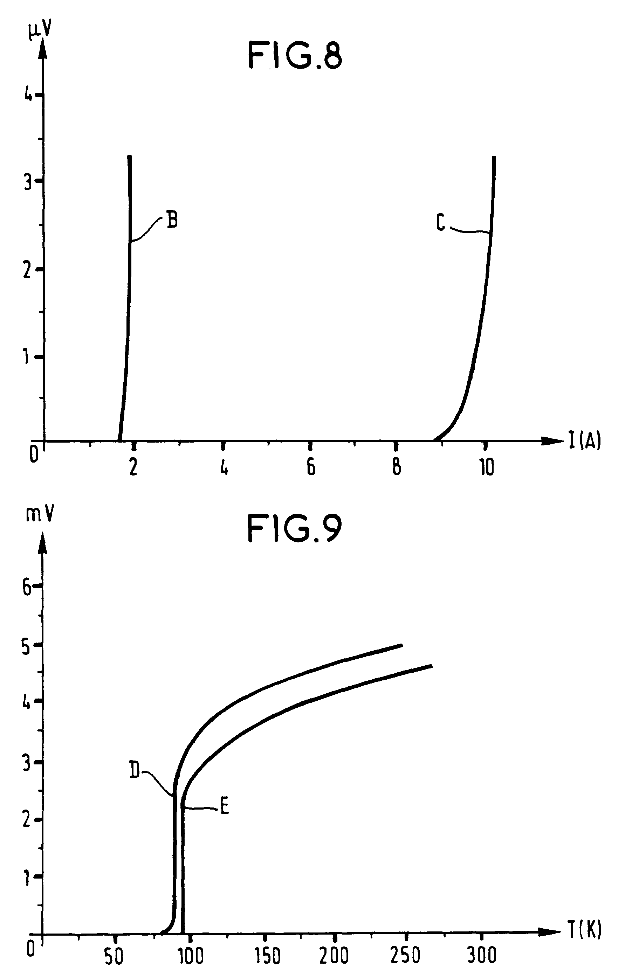

La surface de ce dépôt 22 (figure 5) laisse apparaître de nombreuses fissures. On réalise sur le conducteur obtenu des contacts à l'argent pour mesurer le courant critique. On a reporté dans la figure 8 en abscisses le courant I (ampères) et en ordonnées la tension en micro-volts, on obtient la courbe B. Le courant critique de transport est de 2 ampères (avec 1 µvolt par centimètre) à 77 K, c'est-à-dire 4 ampères par mm. La figure 9 met en évidence la température critique de ce conducteur (courbe D) égale à 84 K.

Selon l'invention on applique sur le dépôt 22 le faisceau 5 issu d'un laser CO₂, de diamètre 5 mm avec une répartition homogène de l'énergie à 10% près, contrôlée au kaléidoscope ; cette énergie est de 800 W/cm2. La fréquence des impulsions est de 500 Hz et la vitesse de balayage V de 20 cm/minute. La température de surface, contrôlée en permanence par le pyromètre bichromatique est de 1500°C.

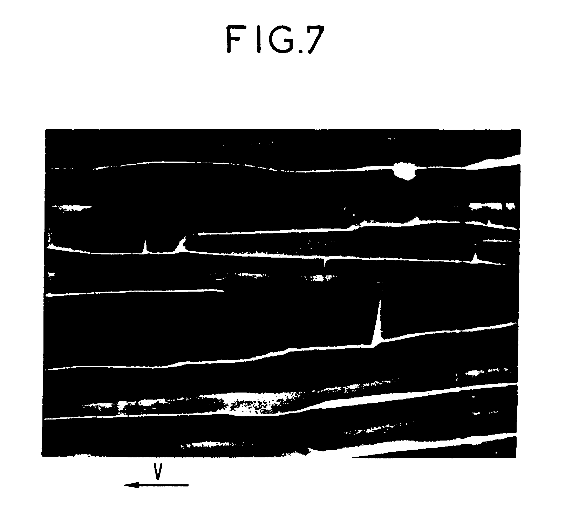

L'épaisseur de la couche fondue 25 est de 40 µm. On effectue le même recuit que pour l'échantillon décrit plus haut. La couche 25 visible dans la figure 6 est sans fissures. Son taux de densification est très proche de 100%. Sa texturation très caractéristique apparaît dans la figure 7. Ses grains sont allongés dans la direction du défilement du ruban (flèche V).

On mesure, comme pour l'échantillon précédent, le courant critique et la température critique du conducteur obtenu (voir courbe C de la figure 8 et courbe E de la figure 9). Le courant critique mesuré à 77 K est 10A, soit 50A/mm et la température critique est de 88 K.

### EXEMPLE II

Le dépôt 22 de l'exemple I est légèrement modifié au niveau de sa composition. On utilise un matériau 12 de type Y₁Ba₂Cu₄Oₓ, enrichi en cuivre ; ceci permet de compenser le départ d'une certaine quantité de cuivre au cours du traitement laser.

Le traitement laser est effectué dans les conditions suivantes ; la fréquence des impulsions est de 300 Hz, l'énergie de 600 W/cm et la vitesse de balayage de 5 cm/minute.

La température de surface est de 1300°C et l'épaisseur de la couche fondue 25 est de 40 µm. Le recuit est identique à celui de l'exemple I. Le courant critique mesuré est 20A, soit 100A/mm.

### EXEMPLE III

Le dépôt 22 n'est plus de 100 µm mais de 150 µm.

Le traitement laser est effectué dans les conditions suivantes : La fréquence des impulsions est de 500 Hz, l'énergie de 1000 W/cm et la vitesse de balayage de 30 cm/minute. La température de surface est de 1600°C et la couche fondue 25 a 100 µm d'épaisseur. Le recuit est identique à celui des exemples précédents. Le courant critique est de 5A, soit 10A/mm.

Bien entendu la présente invention n'est pas limitée aux exemples de réalisation qui viennent d'être décrits. Les matériaux et les épaisseurs des différentes couches peuvent être modifiées comme indiqué plus haut, les paramètres du traitement laser étant alors optimisés en fonction de ces modifications. La sous-couche 21 n'est pas indispensable.

## Revendications

1. Procédé de fabrication d'un conducteur souple supraconducteur à haute température critique selon lequel on applique sur un ruban métallique (1) d'épaisseur comprise entre 0,1 mm et 1 mm un dépôt (22) de céramique supraconductrice, caractérisé par le fait:
- que ledit dépôt (22), d'épaisseur comprise entre 50 µm et 300 µm, avec un taux de densification au moins égal à 70%, défile dans un faisceau infrarouge (5), avec une vitesse au moins égale à 5 cm par minute, la zone traitée par ledit faisceau présentant, dans le sens du défilement, une largeur inférieure à 10 mm et une température de surface au moina égale à 1200°C, de manière à conférer audit dépôt une couche supraconductrice superficielle (25) avec un taux de densification proche de 100%, texturée dans le sens de défilement, présentant une épaisseur comprise entre 10 µm et 100 µm,
- et que l'on effectue ensuite un recuit sous oxygène.

2. Procédé de fabrication selon la revendication 1, caractérisé par le fait que, l'application dudit dépôt sur ledit ruban étant effectuée par une méthode en continu choisie parmi le coulage en bande, le calandrage, la projection par arc électrique, projection par flamme, projection laser, cette application est suivie dans la même opération de fabrication par le traitement par ledit faisceau infrarouge et ledit recuit.

3. Procédé de fabrication selon l'une des revendications 1 et 2, caractérisé par le fait que ladite température de surface est comprise entre 1200°C et 1500°C.

4. Procédé de fabrication selon l'une des revendications 1 à 3, caractérisé par le fait que l'on met en oeuvre un faisceau infrarouge issu d'un laser CO₂ pulsé à une fréquence comprise entre 50 et 1000 Hz avec une puissance comprise entre 100 et 1000 W/cm.

5. Procédé de fabrication selon la revendication 4, caractérisé par le fait que ladite puissance du laser est comprise entre 400 et 800 W/cm.

6. Procédé de fabrication selon l'une des revendications 1 et 2, caractérisé par le fait que l'épaisseur de ladite couche supraconductrice (25) est comprise entre 10 µm et 50 µm.

7. Procédé de fabrication selon l'une des revendications 1, 2, 6, caractérisé par le fait que l'épaisseur dudit dépôt (22) est comprise entre 100 µm et 200 µm.

8. Procédé de fabrication selon l'une des revendications 1 et 2, caractérisé par le fait que l'épaisseur dudit ruban métallique (1) est comprise entre 0,1 mm et 0,5 mm.

9. Procédé de fabrication selon l'une des revendications 1 et 2, caractérisé par le fait que le matériau dudit ruban métallique est choisi parmi le cuivre, l'argent, les aciers inoxydables, les superalliages à base de nickel, les superalliages à base de cobalt.

10. Procédé de fabrication selon la revendication 9, caractérisé par le fait qu'avant la réalisation dudit dépôt, on munit ledit ruban métallique d'une sous-couche (21) destinée à améliorer son adhérence avec ce ruban, ladite sous-couche présentant une épaisseur comprise entre 10 µm et 200 µm, et son matériau étant choisi parmi l'argent, et les alliages de type NiCrAlY, CoCrAlY, NiAl.

11. Procédé de fabrication selon l'une des revendications 1 et 2, caractérisé par le fait que ledit recuit sous oxygène comprend un chauffage jusqu'à une température comprise entre 850°C et 950°C, un palier de durée comprise entre 1 heure et 6 heures à cette température, et une vitesse de refroidissement comprise entre 10°C/heure et 100°C/heure.

12. Procédé de fabrication selon la revendication 11, caractérisé par le fait que ladite vitesse de refroidissement est comprise entre 10°C/heure et 50°C/heure.

13. Procédé de fabrication selon l'une des revendications 1 et 2, caractérisé par le fait que la composition dudit dépôt est enrichie d'éléments susceptibles de se volatiliser au cours du traitement laser.

14. Conducteur souple supraconducteur à haute température critique obtenu par le procédé selon l'une des revendications précédentes.

15. Conducteur souple supraconducteur à haute température critique comprenant un ruban (1) métallique d'épaisseur comprise entre 0,1 mm et 1 mm et un dépôt de céramique supraconductrice (22), caractérisé par le fait que ledit dépôt a une épaisseur comprise entre 50 µm et 300 µm, présente une couche supraconductrice superficielle (25) ayant un taux de densification proche de 100 %, d'épaisseur comprise entre 10 µm et 100 µm, texturée dans le sens de la longueur dudit ruban, et en ce qu'il existe entre ladite couche superficielle (25) et ledit ruban métallique (1) une couche (24) de même nature que ledit dépôt (22).

## Patentansprüche

1. Verfahren zur Herstellung eines supraleitenden biegsamen Leiters mit hoher kritischer Temperatur, gemäß dem man auf ein Metallband (1) einer Dicke zwischen 0,1 mm und 1 mm eine Schicht (22) eines supraleitenden Keramikmaterials aufbringt, dadurch gekennzeichnet, daß
- die Schicht (22) einer Dicke von zwischen 50 µm und 300 µm mit einem Verdichtungsgrad von mindestens gleich 70% unter einem Infrarotstrahl (5) mit einer Geschwindigkeit von mindestens 5cm pro Minute durchläuft, wobei die von diesem Strahl behandelte Zone in Laufrichtung eine Breite von weniger als 10 mm und eine Oberflächentemperatur von mindestens 1200°C aufweist, um der Schicht eine oberflächliche supraleitende Schicht (25) mit einem Verdichtungsgrad nahe 100% zu verleihen, die in Laufrichtung texturiert ist und eine Dicke zwischen 10 µm und 100 µm aufweist,
- und daß man dann ein Brennen unter Sauerstoff durchführt.

2. Herstellungsverfahren nach Anspruch 1, dadurch gekennzeichnet, daß die Schicht auf das Band durch eine kontinuierliche Methode aufgebracht wird, die aus dem Bandgießen, dem Walzen, Aufsprühen durch Lichtbogen, Flammsprühen, Lasersprühen ausgewählt wird, worauf unmittelbar die Behandlung durch den Infrarotstrahl und das Brennen erfolgen.

3. Herstellungsverfahren nach einem der Ansprüche 1 und 2, dadurch gekennzeichnet, daß die Oberflächentemperatur zwischen 1200°C und 1500°C liegt.

4. Herstellungsverfahren nach einem der Ansprüche 1 und 2, dadurch gekennzeichnet, daß ein Infrarotstrahl verwendet wird, der von einem CO₂-Laser kommt, dessen Leistung zwischen 100 und 1000 W/cm liegt und der mit einer Frequenz zwischen 50 und 1000 Hz mit gepulst wird.

5. Herstellungsverfahren nach Anspruch 4, dadurch gekennzeichnet, daß die Leistung des Lasers zwischen 400 und 800 W/cm liegt.

6. Herstellungsverfahren nach einem der Ansprüche 1 und 2, dadurch gekennzeichnet, daß die Dicke der supraleitenden Schicht (25) zwischen 10 µm und 50 µm liegt.

7. Herstellungsverfahren nach einem der Ansprüche 1, 2, 6, dadurch gekennzeichnet, daß die Dicke der Schicht (22) zwischen 100 µm und 200 µm liegt.

8. Herstellungsverfahren nach einem der Ansprüche 1 und 2, dadurch gekennzeichnet, daß die Dicke des Metallbands (1) zwischen 0,1 mm und 0,5 mm liegt.

9. Herstellungsverfahren nach einem der Ansprüche 1 und 2, dadurch gekennzeichnet, daß das Material des Metallbands ausgewählt wird aus Kupfer, Silber, rostfreiem Stahl, Superlegierungen auf der Basis von Nickel und Superlegierungen auf der Basis von Kobalt.

10. Herstellungsverfahren nach Anspruch 9, dadurch gekennzeichnet, daß vor dem Aufbringen der Schicht das Metallband mit einer Unterschicht (21) versehen wird, die die Haftung auf diesem Band verbessern soll, wobei diese Unterschicht eine Dicke zwischen 10 µm und 200 µm aufweist und ihr Material ausgewählt wird aus Silber und den Legierungen NiCrAlY, CoCrAlY, NiAl.

11. Herstellungsverfahren nach einem der Ansprüche 1 und 2, dadurch gekennzeichnet, daß das Brennen unter Sauerstoff eine Erwärmung bis zu einer Temperatur zwischen 850°C und 950°C, ein Verbleiben auf dieser Temperatur zwischen 1 Stunde und 6 Stunden, und eine Abkühlung mit einer Geschwindigkeit zwischen 10°C/Stunde und 100°C/Stunde umfaßt.

12. Herstellungsverfahren nach Anspruch 11, dadurch gekennzeichnet, daß die Abkühlgeschwindigkeit zwischen 10°C/Stunde und 50°C/Stunde liegt.

13. Herstellungsverfahren nach einem der Ansprüche 1 und 2, dadurch gekennzeichnet, daß die Zusammensetzung der Schicht mit Elementen angereichert wird, die sich während der Laserbehandlung verflüchtigen können.

14. Biegsamer supraleitender Leiter mit hoher kritischer Temperatur, der nach dem Verfahren gemäß einem der vorhergehenden Ansprüche hergestellt ist.

15. Biegsamer supraleitender Leiter mit hoher kritischer Temperatur, der ein Metallband (1) einer Dicke zwischen 0,1 mm und 1 mm und eine supraleitende Keramikschicht (22) aufweist, dadurch gekennzeichnet, daß die Schicht eine Dicke zwischen 50 µm und 300 µm hat und eine oberflächliche supraleitende Schicht (25) aufweist, deren Verdichtungsgrad nahe 100% liegt und deren Dicke zwischen 10 µm und 100 µm ist sowie in Richtung der Länge des Bands texturiert ist, und daß zwischen der supraleitenden Schicht (25) und dem Metallband (1) eine Schicht (24) gleicher Art wie die Schicht (22) vorliegt.

## Claims

1. A method of fabricating a superconductive flexible conductor having a high critical temperature in which method a deposit (22) of superconductive ceramic is applied to a metal tape (1) of thickness lying in the range 0.1 mm to 1 mm, the method being characterized by the facts that:
said deposit (22) of thickness lying in the range 50 µm to 300 µm and of concentration by volume of not less than 70% runs through an infrared beam (5) at a speed of not less than 5 cm per minute, the zone treated by the said beam having a width of less than 10 mm relative to the travel direction and a surface temperature of not less than 1200°C, thereby imparting a surface superconductive layer (25) to said deposit which is of concentration by volume close to 100%, which is textured in the travel direction, and which is of thickness lying in the range 10 µm to 100 µm; and
annealing is then performed under oxygen.

2. A method according to claim 1, characterized by the fact that said deposit is applied to said tape using a continuous method selected from: strip casting, calendering, electric arc spraying, flame spraying, and laser spraying, said application being followed in the same fabrication operation by said infrared beam treatment and by said annealing.

3. A method according to claim 1 or 2, characterized by the fact that said surface temperature lies in the range 1200°C to 1500°C.

4. A method according to any one of claims 1 to 3, characterized by the fact that an infrared beam is used from a CO₂ laser pulsed at a frequency lying in the range 50 Hz to 1000 Hz, at a power lying in the range 100 W/cm to 1000 W/cm.

5. A method according to claim 4, characterized by the fact that said laser power lies in the range 400 W/cm to 800 W/cm.

6. A method according to claim 1 or 2, characterized by the fact that the thickness of said conductive layer (25) lies in the range 10 µm to 50 µm.

7. A method according to any one of claims 1, 2, and 6, characterized by the fact that the thickness of said deposit (22) lies in the range 100 µm to 200 µm.

8. A method according to claim 1 or 2, characterized by the fact that the thickness of said metal tape (1) lies in the range 0.1 mm to 0.5 mm.

9. A method according to claim 1 or 2, characterized by the fact that the material of said metal tape is selected from: copper, silver, stainless steels, nickel-based superalloys, and cobalt-based superalloys.

10. A method according to claim 9, characterized by the fact that prior to making said deposit, said metal tape is provided with a sublayer (21) for improving adhesion of the deposit on the tape, said sublayer having a thickness lying in the range 10 µm to 200 µm, and its material being selected from: silver and alloys of the NiCrAlY, CoCrAlY, NiAl type.

11. A method according to claim 1 or 2, characterized by the fact that said annealing under oxygen comprises heating to a temperature lying in the range 850°C to 950°C, a pause at said temperature lying in the range 1 hour to 6 hours, and a cooling speed lying in the range 10°C/hour to 100°C/hour.

12. A method according to claim 11, characterized by the fact that said cooling speed lies in the range 10°C/hour to 50°C/hour.

13. A method according to claim 1 or 2, characterized by the fact that the composition of said deposit is enriched with elements that are liable to vaporize during the laser treatment.

14. A flexible superconductive conductor having a high critical temperature obtained by the method according to any preceding claim.

15. A flexible superconductive conductor having a high critical temperature comprising a metal tape (1) of thickness lying in the range 0.1 mm to 1 mm and a deposit of superconductive ceramic (22), characterized by the fact that said deposit has a thickness lying in the range 50 µm to 300 µm, and has a surface superconductive layer (25) having a concentration by volume close to 100%, of width lying in the range 10 µm to 100 µm, and that is textured in the lengthwise direction of said tape, and in that a layer (24) of the same nature as said deposit (22) exists between said surface layer (25) and said metal tape (1).
